# EUROPEAN PATENT APPLICATION

(11) **EP 4 648 235 A2**
(43) Date of publication of application: **12.11.2025**
(21) Application number: 25181157.6
(22) Date of filing: 20.12.2021
(51) Int. Cl.: H01S 5/026

(54) **SEMICONDUCTOR STRUCTURE FOR PHOTONIC INTEGRATED CIRCUIT AND METHOD OF MANUFACTURE**

(30) Priority: 31.12.2020 GB 202020847
(62) Divisional of application: 21843912.3
(71) Applicant: SMART Photonics Holding B.V., 5656 AE Eindhoven (NL)
(72) Inventor: MILLÁN MEJÍA, Alonso Jesús, 5656 AE Eindhoven (NL); THIJS, Petrus Johannes Adrianus, 5656 AE Eindhoven (NL); VOLPINI, Andrea, 5656 AE Eindhoven (NL)
(74) Representative: EIP

(57) **Abstract**

A semiconductor structure for a photonic integrated circuit, comprising: a substrate; a waveguide on the substrate; a passive region comprising a first cladding layer in contact with a first portion of the waveguide; and an active region comprising a second cladding layer different to the first cladding layer, the second cladding layer in contact with a second portion of the waveguide and the first cladding layer. A third cladding layer, different to the first cladding layer and the second cladding layer, is in contact with the first cladding layer and the second cladding layer, the first cladding layer and the second cladding layer between the waveguide and the third cladding layer. There is a photonic integrated circuit comprising the semiconductor structure. There is a method of manufacturing a semiconductor structure for a photonic integrated circuit.

## Description

### Background

Various semiconductor structures are known. Semiconductor materials can be deposited in different layers one on top of each other to create what may be referred to as a semiconductor structure. Semiconductor materials can be used to define a semiconductor structure which may be used as an active element in a photonic integrated circuit, or to define a semiconductor structure which may be used as a passive element in a photonic integrated circuit. Certain characteristics, such as the doping of certain cladding layers, may be different for a structure used as a passive element compared to a structure used as an active element, for example, to control aspects such as optical losses. It is therefore desirable to improve how to provide a desired amount of dopant in a material such as for a cladding layer.

### Brief Description of the Drawings

Figure 1 illustrates schematically a side cross-section of a first semiconductor structure according to examples;
Figure 2 illustrates schematically a side cross-section of a second semiconductor structure according to examples;
Figure 3 illustrates schematically a plan view of the semiconductor structure of Figure 1 according to examples;
Figure 4 is a flow diagram illustrating a method of manufacturing a semiconductor structure according to examples;
Figure 5 is a flow diagram illustrating examples of a part of the method of manufacturing the semiconductor structure;
Figure 6 is a flow diagram illustrating further examples of a part of the method of manufacturing the semiconductor structure;
Figure 7 is a yet further examples of a part of the method of manufacturing the semiconductor structure;
Figure 8 illustrates schematically a second side cross section of the semiconductor structure of Figure 1 according to examples; and
Figure 9 is a graph showing theoretical simulation data.

### Detailed Description

Examples described herein relate to a semiconductor structure for a photonic integrated circuit (PIC) and a method of manufacturing a semiconductor structure. The semiconductor structure comprises a passive region and an active region monolithically integrated into the same structure. In other words, a PIC with one or more optically functional regions, such as an active region and a passive region, on a single substrate, in other words on a common substrate, can be considered a monolithic PIC.

In examples, the passive region is for passive functions performed by the PIC which do not require an electrical current (for example, a passive waveguide which guides the propagation of light); and the active region is for active functions performed by the PIC which do require electrical current (for example, amplification of light by spontaneous and/or stimulated emission). The passive region comprises a first cladding layer (as described in further detail below) different to a second cladding layer of the active region. The first cladding layer and the second cladding layer are in contact with one another. For example, the second cladding layer is of a different material(s) compared to the first cladding layer.

A semiconductor structure of examples described herein can be manufactured by processing layers of material deposited or otherwise provided on a common substrate, rather than manufacturing separate structures (e.g. on separate substrates) to be used as active and passive elements, then optically connecting them to each other. In examples, different cladding layers are formed for the passive and active regions. Accordingly, the semiconductor structure comprises a passive region and an active region monolithically integrated into the same structure while the cladding layer for each of the passive region and the active region can be independently chosen. Therefore, the need for manufacturing active and passive regions as physically separate structures is avoided.

As used herein, the term material in examples is used to refer to a particular atomic composition of a compound. The particular composition relates to the types of atoms included in the material in question, and also to the relative quantities of those types of atoms. For example, Indium Phosphide is a particular material, while Indium Gallium Arsenide Phosphide (InGaAsP) is referred to as a different material because it also comprises Gallium and Arsenic atoms, making the composition different. For example, doped InP where the dopant is Zinc is referred to as a different material to doped InP where the dopant is Sulphur. Also, for example, p-doped InP with a particular concentration of Zinc as dopant is referred to as a different material to p-doped InP with a different concentration of Zinc as dopant (because the relative quantities of the types of atoms involved are different). Accordingly, a material is referred to as a different material on the basis of having a different dopant concentration.

For example, the material(s) of the first cladding layer is chosen independently of the material(s) of the second cladding layer. For example, the dopant type, dopant concentration, and/or a dopant concentration gradient of the first cladding layer is chosen independently to that of the second cladding layer. Accordingly, in described examples, the first cladding layer is different to the second cladding layer. For example, the second cladding layer comprises a different material or a different set of materials (e.g. p-doped InP with a given dopant concentration in combination with p-doped InP with a higher dopant concentration) to the first cladding layer. In described examples, each of the first cladding layer and the second cladding layer is a discrete layer, and the first cladding layer is in contact with the second cladding layer.

The skilled person will appreciate that it is possible to add a dopant to a layer of initial material by way of dopant diffusion to achieve a final, different material which is doped. In this manner, by applying dopant diffusion to particular regions of a layer of initial material, a layer in which the doping is different in different regions may be provided in order to provide a layer with differing properties in different regions of the layer. However, the control over the diffusion of the dopant atoms may be limited. For example, the diffusion rate of dopant atoms through the initial material depends on what the initial material is. In the case of InP, Zinc atoms have a fast enough diffusion rate so as to not allow enough control over the diffusion to, for example, avoid the Zinc atoms contaminating layers underneath, such as a waveguide layer. For an active region of a PIC (for example, where the PIC is used in a laser application) such contamination is particularly undesired because it would adversely affect the functioning of the active region.

By forming different, discrete cladding layers for the active region and for the passive region in the monolithically integrated structure rather than e.g. applying dopant diffusion to particular regions of a layer of initial material, the doping of the cladding can be controlled to a more precise degree than allowed by dopant diffusion techniques. The examples described herein provide additional design freedom for the composition and arrangement of cladding of the active and passive regions. For example, the first cladding layer can have a different composition to the second cladding layer to an extent not possible with dopant diffusion for example. Discrete (e.g. individual and/or distinct) cladding layers can be formed, as desired, for the active and passive regions.

In examples described herein, the first cladding layer comprises a material for which losses in the passive region (in terms of light propagating through the passive region) are reduced as compared to a comparative case in which the material of the second cladding layer is also used for the passive region. In this manner, the semiconductor structure of present examples comprises monolithically integrated passive and active regions while providing low losses for the passive region.

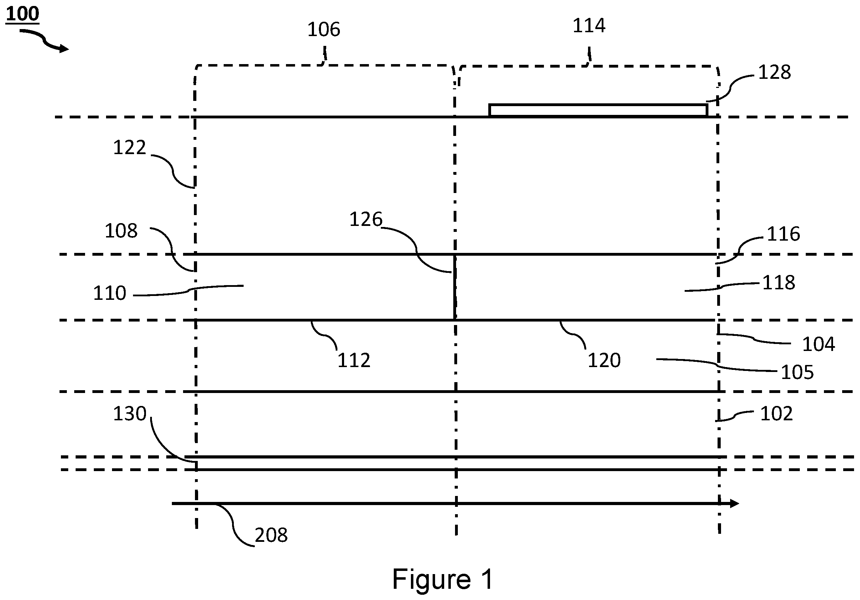

In some examples, the monolithically integrated active and passive regions both comprise a third cladding layer in contact with the first and second cladding layers, the first cladding layer and the second cladding layer between the waveguide and the third cladding layer. The third cladding layer is deposited on top of the first and second cladding layers. In this manner, the cladding of the semiconductor structure is split into an upper region and a lower region (with respect to the orientation shown in Figure 1 described below) between the third cladding layer (in the upper region), and the first and second cladding layers (in the lower region), and the lower region is split into side by side regions of the first and the second cladding layer. This discreteness of the cladding layers means that the composition of the cladding can be controlled depending on the active or passive region of the semiconductor structure and the intended application.

Figure 1 illustrates schematically a side cross section of a part of semiconductor structure 100 according to examples. The numeral 100 is used in Figure 1 to indicate the entire semiconductor structure 100, part of which is shown in Figure 1. As indicated by dashed lines either side of the shown part of the semiconductor structure 100, there are parts to the left and right (with respect to Figure 1) which are not shown for simplicity.

The semiconductor structure 100 encompasses a plurality of examples that may be implemented according to the concepts described herein. The semiconductor structure 100 comprises a substrate 102. For example, the substrate 102 comprises a so-called III-V semiconductor compound such as Indium Phosphide (InP), gallium arsenide (GaAs), gallium nitride (GaN) or gallium antimonide (GaSb). The following examples are in the context of the substrate comprising InP.

In the examples described herein the substrate 102 comprises mainly InP. In some examples, the substrate 102 comprises purely InP (within acceptable purity tolerances). In other examples, the substrate 102 comprises other materials such as dopants or impurities with the material comprising at least 99% InP. For example, the substrate 102 is doped with a dopant material so that the substrate is considered n-doped or the substrate 102 is doped with a dopant material so that the substrate 102 is considered p-doped, or the substrate 102 is doped with a dopant material so that the substrate 102 is considered semi-insulating. The skilled person will appreciate that a given material being n-doped means for example that the given material comprises a donor impurity which contributes free electrons. The skilled person will appreciate that a given material being p-doped means for example that the given material comprises an acceptor impurity which creates holes. In the examples of p-doped InP, the dopant is Zinc, Magnesium or Beryllium, for example. In the examples of n-doped InP, the dopant is Sulphur, Tin, Silicon, Selenium or Tellurium, for example.

In the examples described herein, the substrate comprises n-doped InP. For example, the dopant concentration is between 1× 10¹⁷ and 1 × 10²⁰ *cm*⁻³ (1× 10²³ and 1 × 10²⁶ *m*⁻³). In some examples, the substrate 102 is a single layer of a material. As used herein, a layer may comprise one or more sub-layers. The dopant concentration as referred to herein relates to the main dopant comprised in a material in order to make that material n-doped or p-doped, as the case maybe. For example, for p-doped InP with Zinc, the dopant concentration refers to the concentration of Zinc.

In other examples, the substrate 102 (on which there is provided a waveguide, as will be described below) is a substrate layer comprising two or more sub-layers. In some examples, the substrate layer comprises a lower sub-layer of n-doped or semi-insulating InP and an upper sub-layer of n-doped InP. In some examples, the lower sub-layer is semi-insulating sub-layer comprising InP doped with Iron. In some examples, the upper sub-layer is an n-doped layer comprising InP doped with Sulphur. In such examples, the upper sub-layer being n-doped provides that an electrical contact can be in the upper part of the substrate 102. The upper sub-layer may serve other purposes. For example, the upper sub-layer being n-doped may serve other fabrication related purposes e.g. stop layers for the definition of the semiconductor structure. In examples described herein, the substrate 102 is a layer of n-doped InP.

The dopant concentration of these sub-layers is selected according to the desired application of the semiconductor structure 100, for example. The substrate 102 (whether a single substrate layer of a material of a substrate layer comprising two or more sub-layers) is used as the substrate on which the waveguide is provided, as described below.

The semiconductor structure 100 comprises a waveguide 104 on the substrate 102. In the examples of Figure 1, the waveguide 104 comprises a single waveguide layer 105 on the substrate 102. For example, the waveguide 104 comprises a single waveguide layer 105 comprising a first portion 112 in the passive region and a second portion 120 in the active region. In other examples (described further below) the waveguide 104 comprises more than one (for example, two) waveguide layers arranged side by side with respect to the orientation shown in Figure 1. A waveguide such as the waveguide 104 may also be referred to as a waveguide core. The waveguide core is, for example, the part of the semiconductor structure 100 which is for guiding light, as described below.

In some examples the waveguide layers (one or more layers, as discussed above) comprise a single material. In other examples, one or more of the side by side waveguide layers, as the case may be, comprise two or more sub-layers on top of each other. The following description with reference to Figure 1 is in the context of the waveguide 104 (the waveguide core) comprising a single waveguide layer referred to as waveguide layer 105. Examples in which there are more than one waveguide layers are described further below. The waveguide layer 105 comprises a material which has a higher refractive index than the material of the substrate 102. For example, the waveguide layer 105 comprises Indium Gallium Arsenide Phosphide (InGaAsP).

The waveguide layer 105 is for guiding light. In use, light propagates within the waveguide layer 105 and is confined within the waveguide layer 105, for example in two directions, due to reflection at the boundaries of the waveguide layer 105. The waveguide layer 105 has a refractive index higher than the refractive index of material in contact with the waveguide layer 105 at the boundaries at which confinement of light is desired. For example, due to this refractive index difference at the boundaries at which confinement of light is desired, total internal reflection takes place when the angle of incidence at these boundaries of the waveguide layer 105 is greater than the critical angle. For a particular optical mode to propagate in the waveguide layer 104, the light reflected at the boundaries of the waveguide layer 104 is to fulfil the conditions for constructive interference of that particular optical mode, as will be appreciated by the skilled person.

In some examples, the waveguide layer 105 comprises a uniform layer comprising (Al)InGaAs(P) in contact with the substrate (for example, where the substrate 102 comprises an upper sub-layer of n-doped InP, the uniform layer comprising (Al)InGaAs(P) is in contact with the upper sub-layer of the substrate 102). The amount of each chemical element indicated in the parentheses is chosen in dependence on the desired function. In other examples, the single waveguide layer 105 comprises a plurality of sub-layers. In some such examples, the waveguide layer 105 comprises a (Al)InGaAs(P)/(Al)InGaAs(P) multiple quantum well structure in contact with the substrate 102 (e.g. the upper sub-layer of the substrate 102). The sub layer stack of the waveguide layer 105 has a band gap selected in accordance with the desired application of the semiconductor structure 100.

The semiconductor structure 100 comprises a passive region 106 comprising a first cladding layer 108. The first cladding layer 108 is in contact with a first portion 112 of the waveguide layer 105. The semiconductor structure 100 comprises an active region 114 comprising a second cladding layer 116 different to the first cladding layer 108. The second cladding layer 116 is in contact with a second portion 120 of the waveguide layer 105. The second cladding layer 116 is also in contact with the first cladding layer 108.

As used herein, cladding refers to layers which overlap or contact the waveguide. The function of a given cladding layer which is in contact with the waveguide 104 is to provide particular conditions at the boundary of the waveguide 104 formed by the surface of the waveguide in contact with that given cladding layer. For example, the composition of the given cladding layer is selected according to the desired refractive index change going from the waveguide 104 into the given cladding layer (for example, to confine light by total internal reflection). For example, the composition of the given cladding layer is selected according to the desired electrical properties of the given cladding layer (e.g. it is desired that charge carriers can reach the waveguide 104). A cladding layer which overlaps the waveguide 104 may allow, for example, conduction of charge carrier towards the waveguide 104.

For example, the first cladding layer 108 comprises a III-V semiconductor compound (e.g. InP). For example, the first cladding layer 108 is of a III-V semiconductor compound such as Indium Phosphide (InP), (Al)InGaAs(P) with a suitable bandgap according to the application, gallium arsenide (GaAs), gallium nitride (GaN) or gallium antimonide (GaSb). In the examples being described herein, the first cladding layer 108 is of mainly InP. For example, the first cladding layer 108 is of at least 99% InP.

For example, the second cladding layer 116 comprises a III-V semiconductor compound (e.g. InP). For example, the second cladding layer 116 is of a III-V semiconductor compound such as Indium Phosphide (InP), (Al)InGaAs(P) with a suitable bandgap according to the application, gallium arsenide (GaAs), gallium nitride (GaN) or gallium antimonide (GaSb). In the examples being described herein, the second cladding layer 116 is of mainly InP. For example, the second cladding layer 116 is of at least 99% InP.

In examples, the first cladding layer 108 is n-doped and the second cladding layer 116 is p-doped.. In other examples, the first cladding layer 108 is dopant free and the second cladding layer 116 has a dopant concentration of at least 1 × 10¹⁴*cm*⁻³ (1 × 10²⁰ *m*⁻³). In some such examples, the first cladding layer 108 comprises InP and the second cladding layer 116 comprises InP doped with one of Zinc, Magnesium and Beryllium. In the examples described herein, the first cladding layer 108 comprises InP and the second cladding layer 116 comprises InP doped with Zinc.

For example, the dopant concentration of the second cladding layer 116 is between 1 × 10¹⁴ and 1 × 10²⁰*cm*⁻³ (1× 10²⁰ and 1 × 10²⁶ *m*⁻³). In the examples described herein, the substrate 102 comprises n-doped InP. In these examples, the second cladding layer 116 is p-doped in order to form a p-n (or p-i-n junction) in the active region 114. In the examples described herein, the first cladding layer 108 is dopant free.

As described above, the first and second cladding layers 108, 116 may be of a material other than InP, such as InGaAsP, for example. Accordingly, the first and second cladding layers are not limited to the above described examples. In examples where InGaAsP is used, the layer in question may be p-doped with one of Zinc, Magnesium, Beryllium and Carbon, and the layer in question may be n-doped with one of Sulphur, Tin, Silicon, Selenium and Tellurium.

In some examples, the first second cladding layers 108, 116 have a dopant concentration (if they are doped - note that in some examples, the first cladding layer 108 is dopant free) that is substantially (within acceptable tolerances) homogeneous throughout the layer in question. For example, the first cladding layer 108 is of a first material 110 and the second cladding layer is of a second material 118 different to the first material 110(see Figure 1). As described above, as used herein, the term material in examples is used to refer to a particular atomic composition of a compound. The particular composition relates to the types of atoms included in the material in question, and also to the relative quantities of those types of atoms.

In other examples, the dopant concentration of one or both of the first and second cladding layers 108, 116 changes with position in the layer in question. Accordingly, one or both of the first and second cladding layers 108, 116 may comprise a set of materials such that the dopant concentration changes with position in the layer in question. The term set of materials, as used herein, is not limited to a layer composed of discrete steps in dopant concentration, for example, and may exhibit a gradual change in dopant concentration with position.

In examples, the first cladding layer 108 is different to the second cladding layer 116 in that the first and second cladding layers 108, 116 comprise different materials or different sets of materials.

In some examples, the second cladding layer 116 has a dopant concentration that is homogeneous (within acceptable tolerances) throughout the second cladding layer 116. In other examples, the dopant concentration of the second cladding layer 116 changes with distance from the waveguide 104. For example, the lowest dopant concentration is nearest the waveguide layer 105 and the dopant concentration increases as the distance from the waveguide layer 105 (e.g. further up the second cladding layer 116 and away from the waveguide layer 105 with respect to the orientation shown in Figure 1). Having a lower dopant concentration closest to the waveguide e.g. provides lower losses (in terms of absorption of light by charge carriers) while still allowing conduction of charge carriers within the layer in question.

The first portion 112 and the second portion 120 of the waveguide layer 105 are in the same plane. In the orientation shown in Figure 1, the first portion 112 and the second portion 120 are part of a top surface of the waveguide layer 105. Accordingly, a surface of the first cladding layer 108 is in contact the second cladding layer 116. In the examples of Figure 1, the first cladding layer 108 has a side surface in contact with a side surface of the second cladding layer 116. The contact between the side surfaces of the first and second cladding layers 108, 116 may be referred to as a first butt joint 126.

In the examples of Figure 1, the semiconductor structure 100 comprises a third cladding layer 122 different to the first cladding layer 108 and the second cladding layer 116. The third cladding layer 122 is in contact with the first cladding layer 108 and the second cladding layer 116. The first cladding layer 108 and the second cladding layer 116 are between the waveguide 104 and the third cladding layer 122. In some examples, the third cladding layer 122 is omitted.

For example, the third cladding layer 122 comprises a III-V semiconductor compound (e.g. InP). For example, the third cladding layer 122 is of a III-V semiconductor compound such as Indium Phosphide (InP), (Al)InGaAs(P) with a suitable bandgap according to the application, gallium arsenide (GaAs), gallium nitride (GaN) or gallium antimonide (GaSb). In the examples being described herein, the third cladding layer 122 is of mainly InP. For example, the third cladding layer 122 is at least 99% InP. The third cladding layer 122 is either p-doped or n-doped. The type of doping of the third cladding layer 122 is opposite to the type of doping of the substrate 102. In the examples described herein, the third cladding layer 122 is p-doped. In examples described herein, the third cladding layer 122 is of InGaAs.

The third cladding layer 122 is different to the second cladding layer 116 in that the third cladding layer 122 is of a different material (or different set of materials). For example, the third cladding layer 122 comprises a higher concentration of dopant atoms. For example, the dopant concentration of the third cladding layer 122 is at least 5 × 10¹⁷ *cm*⁻³(5× 10²³*m*⁻³). For example, the dopant concentration is between 5 × 10¹⁷ and 2 × 10¹⁸ *cm⁻³* (1× 10²³ and 1 × 10²⁴ *m*⁻³). In some examples, the dopant concentration of the third cladding layer 122 changes with distance from the waveguide. For example, the lowest dopant concentration may occur closest to the waveguide and the dopant concentration may be higher at greater distances from the waveguide.

In the examples of Figure 1, the first cladding layer 108 and the second cladding layer 116 have substantially (within acceptable tolerances) the same thickness. This means that the semiconductor structure 100 can be manufactured using an integrated manufacturing method, as described further below.

In the examples of Figure 1, there is provided different cladding in contact with the waveguide layer 105 in the passive region 106 than in the active region 114. The second cladding layer 116 comprised in the active region 114 is p-doped so that it is conductive. For example, charge carriers can be supplied to the second portion 120 of the waveguide layer 105 in the active region 114. The p-doped second cladding layer 116 means that there is a p-n (or p-i-n, depending on whether or not the second portion 120 of the waveguide layer 105 is doped or dopant free) junction formed with the n-doped substrate 102 in the active region 114.

However, the skilled person will appreciate that having a p-doped cladding in contact with a waveguide layer in a passive region increases optical losses of that waveguide layer. In described examples of the semiconductor structure 100, the first cladding layer 108 is dopant free and in contact with the first portion 112 of the waveguide layer 105 in the passive region 106. This reduces optical losses in the passive region 106 compared to the first portion 112 being in contact with p-doped material. In examples in which the first cladding layer 108 is n-doped, the optical losses are also lower as compared to the first portion 112 instead being in contact with a p-doped material.

Accordingly, the semiconductor structure 100 comprises monolithically integrated passive 106 and active 114 regions and providing the different cladding in contact with the passive region 106 compared to the active region 114 reduces optical losses in the passive region 106.

The p-doped third cladding layer 122 is in contact with the first cladding layer 108 and the second cladding layer 116 in the examples of Figure 1. The thickness (between the waveguide layer 105 and the third cladding layer 122) of the first cladding layer 108 is selected depending upon the desired balance between a reduction in optical losses and manufacturing characteristics of the first, second and third cladding layers. For example, the thicker the first cladding layer 108, the greater the reduction in optical losses in the passive region 106. However, this reduction in optical losses is not linear. As the thickness of the first cladding layer 108 increases, at some point the reduction in optical losses becomes small.

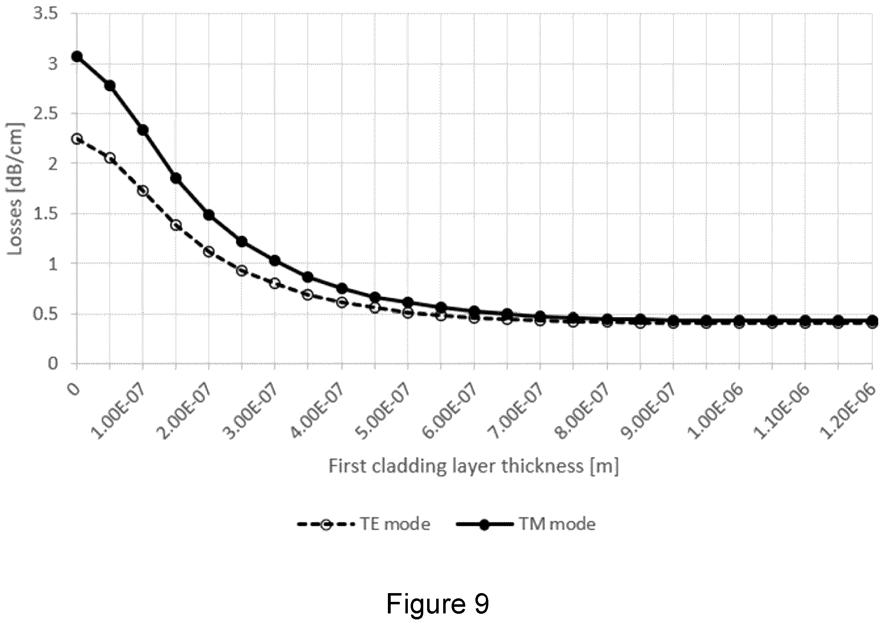

Figure 9 is a graph 900 showing theoretical simulation data for optical losses with respect to the thickness of the first cladding layer 108. The horizontal axis of the graph 900 represents the thickness of the first cladding layer 108. The vertical axis of the graph 900 represents optical losses in units of dB/cm. Optical loss data is shown for the transverse electric (TE) modes using unfilled circles and a dashed line. Optical loss data is shown for the transverse magnetic (TM) modes using filled circles and a solid line. The data of graph 900 shows a non-linear reduction in optical losses with increasing first cladding layer thickness.

As described above, the first cladding layer 108 and the second cladding layer 116 contact one another at the first butt joint 126. The thicker the first and second cladding layers (and the greater the height of the first butt joint 126), the more likely that there will be a structural disturbance at, for example, the respective top surfaces (with respect to the orientation shown in Figure 1) of the first and second cladding layers at the first butt joint 126. For example, if the first and second cladding layers are very thick, there are dips and/or bumps at the top surface of the first and/or the second cladding layer at or close to the first butt joint 126. The skilled person will appreciate that it is desirable to have uniform surfaces without such structural disturbances. For example, if there are significant structural disturbances, there may be undesired strain in the structure. For example, if there are significant structural disturbances, other layers formed on top may be affected. For example, if there are significant structural disturbances at the first butt joint 126, the third cladding layer 122 has strain and/or has a non-uniform top surface. During fabrication, it may be desired to minimise (to an acceptable level) these disturbances to avoid undesired topographical features, for example, in relation to parts of the semiconductor structure 100 desired to be fabricated with tightly controlled tolerances (e.g. the waveguide 104).

Accordingly, the thickness of the first and second cladding layers is selected to reduce or minimize (to an acceptable level) structural disturbances near the first butt joint 126 while providing a reduction in optical losses. For example, the thickness of the first cladding layer 108 and the second cladding layer 116 is between 0.1 and 2 micrometres. In some examples, the thickness of the first and second cladding layers 108, 116 is greater than 0.4 micrometres (4 × 10⁻⁷ *m*). It will be appreciated that a micrometre is 1 × 10⁻⁶ *m*. In some examples, the first and second cladding layers are more than or equal to 0.4 and/or less than or equal to 2 micrometres thick.

The region of the semiconductor structure 100 comprising the first, second and third cladding layers can be referred to as the cladding region. The cladding region is split into side by side regions with respect to the orientation shown in Figure 1 between the first cladding layer 108 and the second cladding layer 116. This split of different discrete layers of different composition means that the material in contact with the waveguide layer 105 in the passive region 106 and the active region 114 can be individually controlled. In described examples, the first cladding layer 108 is dopant free for reducing optical losses in the passive region 106 and the second cladding layer 116 is p-doped for conduction of charge carriers. However, in other examples, the composition of the first cladding layer 108 and the second cladding layer 116 is different depending on the intended application of the semiconductor structure 100.

The cladding region is also split into an upper region and a lower region (with respect to the orientation shown in Figure 1) between the third cladding layer 122 (upper region) and the first 108 and second 116 cladding layers (lower region). This means that the total desired thickness of the cladding region can be provided without the height of the first butt joint 126 being so large as to create significant structural disturbances. This also means that the properties of the cladding region can be different with distance from the waveguide layer 105 according to the desired application.

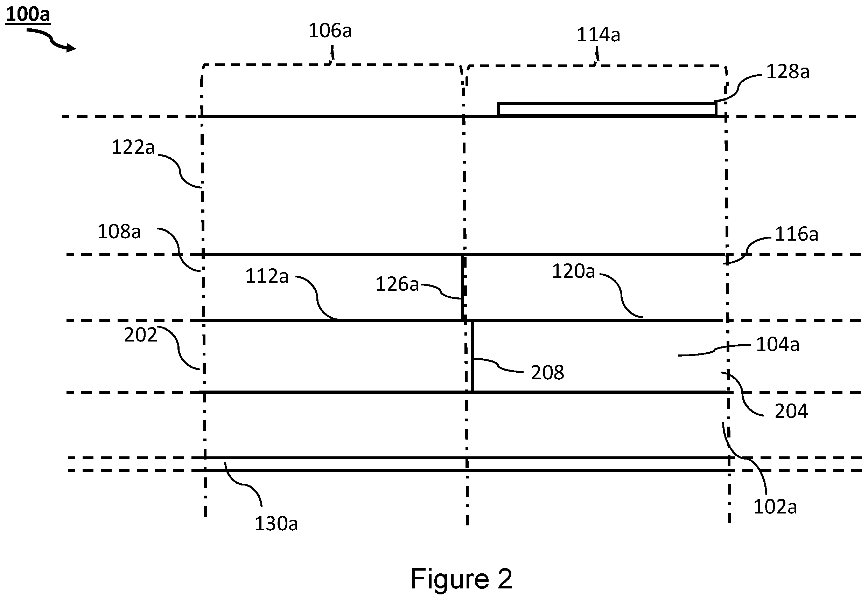

Figure 2 illustrates schematically a side cross section of a part of a semiconductor structure 100a (hereafter referred to as semiconductor structure 100a) according to examples. The numeral 100a is used in Figure 2 to indicate the entire semiconductor structure 100a, part of which is shown in Figure 2. Figure 2 relates to examples in which the waveguide 104a comprises two waveguide layers. Features shown in Figure 2 which correspond to the features shown in Figure 1 are labelled with the same reference numeral with an "a" appended to the end of the reference numerals. For brevity, certain reference numerals are omitted. In these examples, the waveguide 104a comprises a first waveguide layer 202 in the passive region 106a, and the waveguide 104a comprises a second waveguide layer 204 in the active region 114a. The first waveguide layer 202 is different to the second waveguide layer 204. The first waveguide layer 202 is in contact with the second waveguide layer 204.

In the examples of Figure 2, the first portion 112a of the waveguide 104a comprises the first waveguide layer 202, and the second portion 120a of the waveguide 104a comprises a second waveguide layer 204. The first waveguide layer 202 is in contact with the second waveguide layer 204.

The first waveguide layer 202 is for the passive region 106a of the semiconductor structure 100a and the second waveguide layer 204 is for the active region 114a. The first waveguide layer 202 comprises any of the features (and/or any combination of the features) described with respect to the single waveguide layer 105 in the context of Figure 1. In some examples, the second waveguide layer 204 comprises one material. For example, the material of the second waveguide layer 204 is suitable for an active device. For example, the material of the second waveguide layer 204 has a bandgap corresponding to the wavelength of light for which the semiconductor structure 100a is intended to be used.

In some examples, the second waveguide layer 204 comprises a uniform layer comprising (Al)InGaAs(P) in contact with the substrate (for example, where the substrate 102 comprises an upper buffer sub-layer of n-doped InP, the uniform layer comprising (Al)InGaAs(P) is in contact with the upper buffer sub-layer of the substrate 102).

In other examples, the second waveguide layer 204 comprises a plurality of stacked sub-layers. In some such examples, the second waveguide layer 204 comprises a (Al)InGaAs(P)/(Al)InGaAs(P) multiple quantum well structure in contact with the substrate 102 (e.g. the upper buffer sub-layer of the substrate 102). In some examples, the plurality of sub-layers of the second waveguide layer 204 include alternating sub-layers of InP and InGaAsP. Individual sub-layer thickness, number of sub-layers, sub-layer doping, the use of Aluminium instead of Phosphorus, exact proportion of the elements in InGaAsP or AlInGaAs, for example, is different according to the desired application.

The band gap of the sub-layer stack of the second waveguide layer 204 is smaller than the band gap of the first waveguide layer 202 (e.g. the band gap of the sub-layer stack described above in the context of Figure 1), for example. As described above, the second waveguide layer 204 is for the active region 114a. The band gap of the sub-layer stack of the second waveguide layer 204 is tuned according to the application of the active region 114a, and the band gap corresponding to the first waveguide layer 202 is larger.

In some examples, photons are emitted due to electron hole recombination within the second waveguide layer 204 according to the band gap corresponding to the second waveguide layer 204. The band gap of the first waveguide layer 202 is larger so that those photons are not absorbed in the first waveguide layer 202 due to promotion of electrons from the valence band into the conduction band. The first waveguide layer 202 for the passive regions 106a is for guiding the light rather than absorbing or emitting light.

The first waveguide layer 202 is in contact with the second waveguide layer 204. A surface of the first waveguide layer 202 is in contact with the second waveguide layer 204. In the examples of Figure 2, the first waveguide layer 202 has a side surface in contact with a side surface of the second waveguide layer 204. The contact point between the side surfaces of the first and the second waveguide layers 202, 204 may be referred to as a second butt joint 206. A butt joint can be considered as a join where a surface of a layer abuts a surface of another layer.

In the examples of Figure 2, the surface (e.g. side surface) of the first cladding layer 108a in contact with the second cladding layer 116a is offset from a surface (e.g. a side surface) of the first waveguide layer 202 in contact with the second waveguide layer 204. In other words, in the examples of Figure 2, the second butt joint 206 is offset from the first butt joint 126a. This means that the second butt joint 206 is at a different location than the first butt joint 126a along a direction indicated by arrow 208. For example, the plane of the surface of the first cladding layer 108a in contact with the second cladding layer 116a is not aligned with the plane of the surface of the first waveguide layer 202 in contact with the second waveguide layer 204. In other words, the surface of the first cladding layer 108a in contact with the second cladding layer 116a is in a different plane than the surface of the first waveguide layer 202 in contact with the second waveguide layer 204.

As described above, structural disturbances within the semiconductor structure are to be minimised (within acceptable tolerances). The thickness of the first waveguide layer 202 and the second waveguide layer 204 determine the magnitude of any structural disturbances at or near the second butt joint 206. Providing an offset between the first butt joint 126a and the second butt joint 206 can be considered to provide that the influence of any structural disturbances at the second butt joint 206 on any structural disturbances at the first butt joint 126a are reduced.

For example, if the first butt joint 126a and the second butt joint 206 are at the same position with respect to the direction 208, a bump on the top surface (with respect to the orientation shown in Figure 2) of the first waveguide layer 202 near the second butt joint 206 may cause there to be an even larger bump on the top surface (with respect to the orientation shown in Figure 2) of the first cladding layer 108a near the first butt joint 126a during manufacture. However, this effect is avoided due to the described offset.

In other examples, the offset may not be present, for example due to other considerations (such as manufacturing ease and efficiency) being given greater importance than the minimization of structural disturbances.

Referring again to the semiconductor structure 100 illustrated in Figure 1, the active region 114 comprises an electrical contact 128 for injecting charge carriers into the active region 114 (shown in Figure 2 as electrical contact 128a). For example, the electrical contact 128, 128a is in the form of one or more metal strips or plates that allow electrical connection. The electrical contact 128, 128a can be used to create a potential difference for the conduction of charge carriers in the active region 114, 114a. For example, the electrical contact 128. 128a is a first electrical contact 128, 128a and the semiconductor structure 100, 100a comprises a second electrical contact 130, 130a in the form a second contact layer 130, 130a in contact with a surface of the substrate furthest from the first electrical contact. The second electrical contact 130, 130a is in contact with the n-doped part of the substrate 102, 102a. In examples where the substrate 102, 102a comprises an upper sub-layer that is n-doped, the second electrical contact 130, 130 is in contact with the n-doped upper sub-layer. The active region 114, 114a comprises the first cladding layer 108, 108a and the second portion 120, 120a of the waveguide 104, 104a between the electrical contact 128, 128a and the substrate 102, 102a. For example, the passive region 106, 106a comprises the first portion 112, 112a of the waveguide 104, 104a not overlapped by the electrical contact 128, 128a.

In some examples, such as those described herein with the substrate 102, 102a being n-doped and the second cladding layer 116, 116a and the third cladding layer 122, 122a being p-doped, the first electrical contact 128, 128a is set at a positive voltage with respect to the second electrical contact 130, 130a, which is typically grounded (e.g. at zero volts), though may instead be floating. In some such examples (according to the application), the resulting potential difference provides population inversion within the second waveguide layer 204 so that photons can be emitted due to electron-hole recombination.

In some examples, the semiconductor structure 100, 100a comprises additional layers of material not shown in Figure 1 and 2. In some examples, the semiconductor structure 100, 100a comprises a highly p-doped layer of InGaAs on top of (with respect to the orientation shown in Figure 1) the third cladding layer 122, 122a. Such a layer is included for increased charge carrier conduction, for example. In some examples, the semiconductor structure 100 includes other layers according to the application and/or the particular manufacturing method of the semiconductor structure 100, 100a.

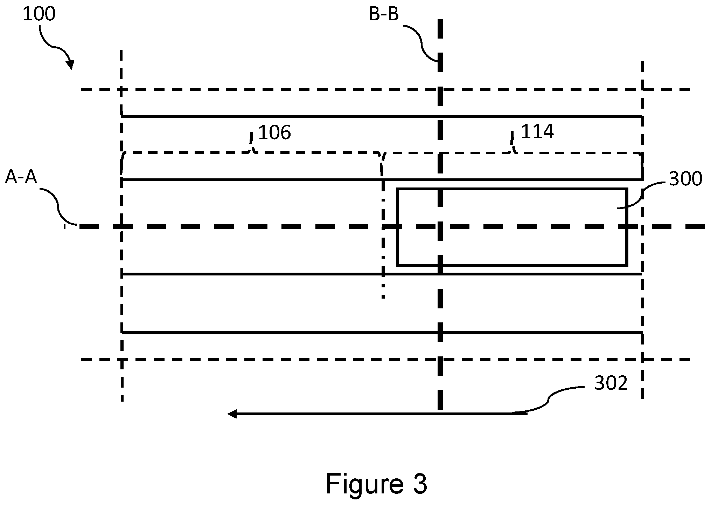

Figure 3 illustrates schematically a plan view of a part of the semiconductor structure 100, 100a (the dashed lines at the boundaries of the illustrations indicate that there are parts that are not shown for simplicity). There is shown an active device 300 connected to the semiconductor structure 100, 100a on top of the active region 114, 114a. The dashed lines in Figure 3 indicate parts of the semiconductor structure 100, 100a not shown in Figure 3. Dashed line A-A is the line along which the side cross section of Figure 1 and Figure 2 is taken. In some examples, light emitted at the active region 114, 114a is guided through the passive region 106, 106a in the direction shown by arrow 302.

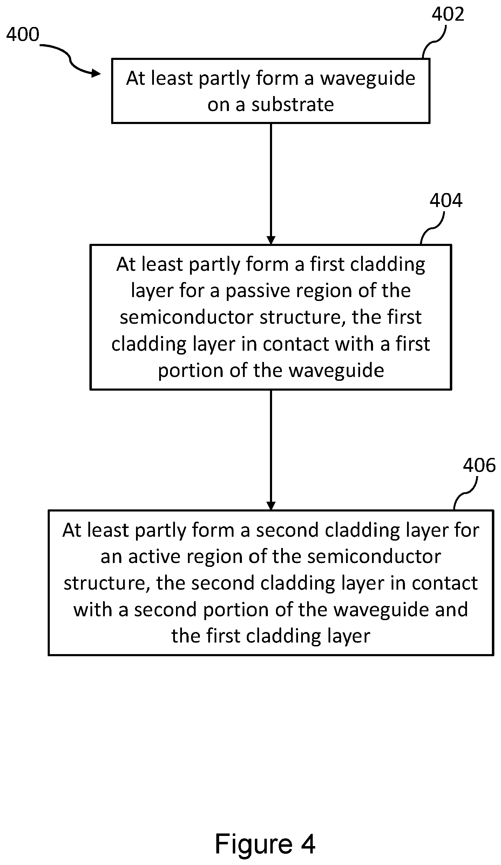

Figure 4 is a block diagram illustrating a method 400 of manufacturing a semiconductor structure for a PIC according to examples. For example, the method 400 is used to manufacture any of the examples of semiconductor structure 100, 100a. The method 400 is hereafter described by referring to the features described with respect to Figures 1 to 3 and in the context of described examples.

In some examples, the method 400 starts with the substrate 102, 102a. At block 402 of the method 400, the waveguide is at least partly formed on a substrate. For example, one or more materials for a waveguide are deposited to at least partly form the waveguide (e.g. the waveguide 104, 104a) on the substrate 102, 102a. In other examples, the starting point of the method 400 is a wafer of InP onto which the substrate layer 102, 102a is grown before block 402 is performed. At block 404, a first cladding layer for a passive region of the semiconductor structure is at least partly formed, the first cladding layer in contact with a first portion of the waveguide. For example, one or more materials for the first cladding layer are deposited to at least partly form a first cladding layer (e.g. the first cladding layer 108, 108a) comprised in a passive region (e.g. the passive region 106, 106a). The first cladding layer 108, 108a is at least partly formed such that it is in contact with the first portion 112, 112a of the waveguide. In examples, where the first cladding layer comprises a dopant concentration gradient, dopant atoms may be introduced in progressively increasing amounts as the first cladding layer 108, 108a is deposited, for example.

At block 406, a second cladding layer for an active region is at least partly formed, the second cladding layer in contact with a second portion of the waveguide and the first cladding layer. For example, one or more materials for the second cladding layer are deposited to at least partly form a second cladding layer (e.g. the second cladding layer 116, 116a) comprised in an active region (e.g. the active region 114, 114a). The second cladding layer is defined such that it is in contact with a second portion (e.g. the second portion 120, 120a) of the waveguide and the first cladding layer 108, 108a. In examples, where the second cladding layer comprises a dopant concentration gradient, dopant atoms may be introduced in progressively increasing amounts as the second cladding layer 116, 116a is deposited, for example.

It should be noted that blocks 402 to 406 can be performed in any order and/or concurrently. For example, the passive and active regions are defined concurrently.

In examples comprising the third cladding layer, the method 400 further comprises at least partly forming the third cladding layer (e.g. the third cladding layer 122, 122a) on a top surface of the first cladding layer 108, 108a and a top surface of the second cladding layer 116, 116a, the third cladding layer 122, 122a in contact with the first cladding layer 108, 108a and the second cladding layer 116, 116a. As referred to herein, a top surface of a layer is with respect to the orientation shown in Figures 1 and 2.

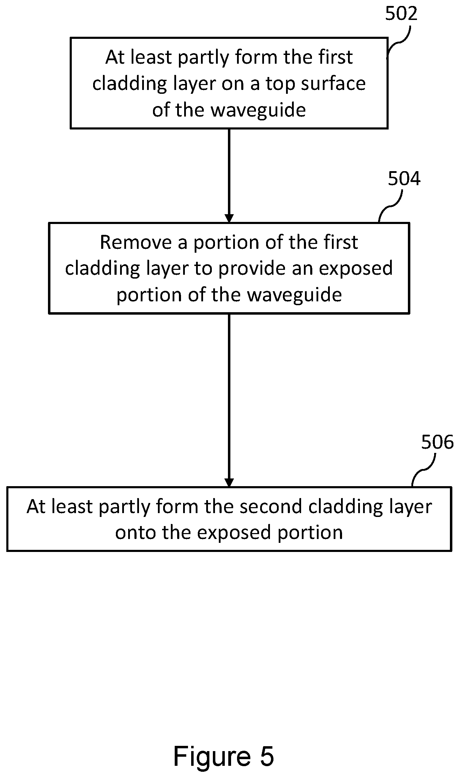

Hereafter, more specific examples of the method 400 are described. Figure 5 is a block diagram illustrating more specific examples relating to defining the passive region 106, 106a and the active region 114, 114a. Blocks 502 to 506 shown in Figure 5 illustrate a more specific examples of blocks 404 and 406 of the method 400. In other words, Figure 5 relates to at least partly forming the first cladding layer 108, 108a and at least partly forming the second cladding layer 116, 116a.

At block 502, the first cladding layer 108, 108a is at least partly formed on a top surface (for example, to cover substantially all of a top surface) of the waveguide 104, 104a. For example, starting with the substrate 102, 102a with the waveguide 104, 104a in contact with a top surface of the substrate 102, 102a, the first cladding layer 108, 108a is deposited on the surface of the waveguide 104, 104a which is opposite the surface of the waveguide 104, 104a in contact with the substrate 102, 102a.

At block 504, a portion of the first cladding layer 108, 108a is removed to provide an exposed portion of the waveguide 104, 104a. In some examples, two or more portions of the first cladding layer 108, 108a are removed to provide two or more respective exposed portions of the waveguide 104, 104a. The number, arrangement, size and the like of the portions that are removed depends upon where the passive and active regions are desired and fabrication capabilities.

In the examples of Figure 5, the exposed portion is where the second cladding layer 116, 116a is desired to be deposited according to the application of the semiconductor structure being manufactured. For example, the exposed portion is where the passive region 106, 106a is to be defined. At block 506, the second cladding layer 116, 116a is at least partly formed on the exposed portion. Block 506 represents examples of at least partly forming the second cladding layer 116, 116a. For example, the second cladding layer 116, 116a is deposited onto the exposed portion. The thickness of the second cladding layer 116, 116a deposited onto the exposed portion is substantially the same (within acceptable tolerances) as the thickness of the first cladding layer 108, 108a.

In some examples, the first cladding layer 108, 108a and the second cladding layer 116, 116a are simply formed by depositing the respective materials without requiring further steps. In other examples, the first cladding layer 108, 108a and the second cladding layer 116, 116a are not formed completely after deposition of the respective materials and further steps are required (for example, a curing step, etc.). In some examples, the further steps are performed before further material is deposited on top of the first and second cladding layers 108, 108a, 116, 116a. In other examples, the further steps are performed after further material (e.g. for the third cladding layer 122, 122a) is deposited on the first and second cladding layers 108, 108a, 116, 116a. In examples in which there are further layers (such as the third cladding layer 122, 122a, the first electrical contact 128, 128a and the like), the formation of the passive and active regions 106, 106a, 114, 114a is completed by defining these further layers, as the case may be.

In some examples, the converse of the blocks illustrated in Figure 5 are performed. For example, the second cladding layer 116, 116a is deposited on the top surface (e.g. to substantially cover all of the top surface) of the waveguide 104, 104a. Then, a portion of the second cladding layer 116, 116a is removed to create an exposed portion of the waveguide 104, 104a. Then, the first cladding layer 108, 108a is deposited onto the exposed portion. In some examples, two or more portions of the second cladding layer 116, 116a are removed to provide two or more respective exposed portions of the waveguide 104, 104a. The number, arrangement, size and the like of the portions that are removed depends upon where the passive and active regions are desired. In such examples, the one or more exposed portions of the waveguide 104 are at locations intended for passive functions.

The examples of Figure 5 and the converse described examples mean that the first butt joint 126, 126a between the first and second cladding layers 108, 108a, 116, 116a is defined. Accordingly, the first cladding layer 108, 108a and the second cladding layer 116, 116a contact one another at the first butt joint 126, 126a.

Referring again to Figure 4, at block 402 more than one waveguide layer is defined in some examples. These examples relate to the manufacture of the semiconductor structure 100a, for example. In some examples, in the method 400, the waveguide 104a comprises a first waveguide layer (e.g. the first waveguide layer 202) in the passive region 106a, and the waveguide 104a comprises a second waveguide layer (e.g. the second waveguide layer 204) in the active region 114a. The first waveguide layer 202 is in contact with the second waveguide layer 204. The following are examples of the first and second waveguide layers 202, 204 being at least partly formed.

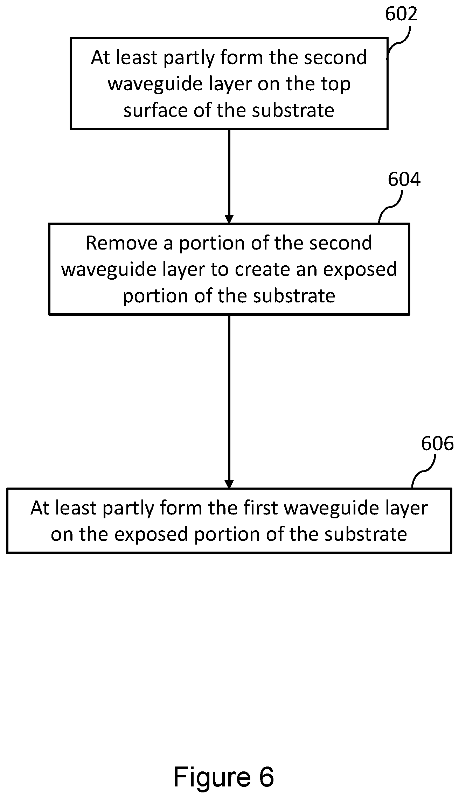

Figure 6 is a block diagram illustrating some specific examples relating to defining the first and second waveguide layers 202, 204. At block 602, the second waveguide layer 202 is at least partly formed on a top surface (e.g. to substantially cover all of the top surface) of the substrate 102a. For example, one or more materials for the second waveguide layer 204 are deposited to cover the top surface of the substrate 102a. For example, as described above, the second waveguide layer 204 comprises a sub-layer stack. Taking a particular set of examples, at block 602, material is deposited to define a (Al)InGaAs(P)/(Al)InGaAs(P) multiple quantum well structure to cover the top surface of the substrate 102a. The skilled person will appreciate that techniques for defining multiple quantum well structures are known.

At block 604, a portion of the second waveguide layer 204 is removed to provide an exposed portion of the substrate 102a. In the case of the above introduced examples, the (Al)InGaAs(P)/(Al)InGaAs(P) multiple quantum well structure is removed to provide the exposed portion. The position of the exposed portion is selected according to the desired location of the passive region of the structure. In some examples, two or more portions of the second waveguide layer 204 are removed to provide two or more respective exposed portions of the substrate 102a. The number, arrangement, size and the like of the portions that are removed depends upon where the passive and active regions are desired and the fabrication capabilities.

At block 606, the first waveguide layer 202 is at least partly formed on the exposed portion of the substrate 102a. For example, one or more materials for the first waveguide layer 202 are deposited onto the exposed portion of the substrate 102a. Taking a specific set of examples, material is deposited to define a (Al)InGaAs(P)/(Al)InGaAs(P) multiple quantum well structure which has a larger band gap than that of the second waveguide layer 204. In some examples, the total thickness of the materials for the first waveguide layer 202 is substantially the same (within acceptable tolerances) as the total thickness of the materials for the second waveguide layer 204. In other examples, the thickness of the first waveguide layer 202 and the second waveguide layer 204 are slightly different from each other to account for the slightly different refractive indices of these layers, for example. Accounting for differences in the refractive index in this manner may provide better coupling of the optical mode between the first waveguide layer 202 and the second waveguide layer 204. In some examples, to avoid steps or discontinuities between the respective top surfaces of the first waveguide layer 202 and the second waveguide layer 204, when these layers have slightly different thicknesses, an additional layer is added to the less thick of the layers so as to form a continuous top surface, for example.

In some examples, the first waveguide layer 202 and the second waveguide layer 204 are simply formed by depositing the respective materials without requiring further steps. In other examples, the first waveguide layer 202 and the second waveguide layer 204 are not formed completely after deposition of the respective materials and further steps are required (for example, a curing step, etc.). **In** some examples, the further steps are performed before further material is deposited on top of the first and second waveguide layers 202, 204. In other examples, the further steps are performed after further material (e.g. the first and second cladding layers 108a, 116a) is deposited on the first and second waveguide layers 202, 204.

In some examples, the converse of the blocks illustrated in the examples of Figure 6 are performed. In some such examples, the first waveguide layer 202 is at least partly formed on the top surface of the substrate 102a (e.g. to cover substantially all of the top surface). For example, one or more materials for the first waveguide layer 202 (instead of the one or more materials for the second waveguide layer 204 as in the example described above with reference to Figure 6) are deposited on the top surface of the substrate 102a. A portion (or two or more portions, as the case may be) of the first waveguide layer 202 are removed to create an exposed portion (or respective two or more exposed portions) of the substrate 102a. Then, the second waveguide layer 204 is at least partly formed on the exposed portion of the substrate. For example, one or more materials for the second waveguide layer 204 are deposited onto the exposed portion of the substrate 102a.

The examples of Figure 6 and described converse examples mean that the second butt joint 208 between the first and second waveguide layers 202, 204 are defined. Accordingly, the first waveguide layer 202 and the second waveguide layer 204 contact one another at the second butt joint 204. The examples of Figure 6 or the examples converse to Figure 6 relating to defining the first and second waveguide layers 202, 204 can be used together with the examples of Figure 5 or the examples converse to Figure 5 relating to defining the first and second cladding layers 108a, 116a. Accordingly, using the relevant described method blocks, the first butt joint 126a and the second butt joint 208 can be defined. In some examples, a surface of the first cladding layer 108a in contact with the second cladding layer 116a is offset from a surface of the first waveguide layer 202 in contact with the second waveguide layer 204. In other words, in some examples, the first and second butt joints 126a, 208 are formed such that the first butt joint 126a is offset from the second butt joint 208. In some of these examples, the previously described offset between the different butt joints can be achieved simply by selecting appropriately the portions of the material in question being removed to create respective exposed portions of the layer underneath.

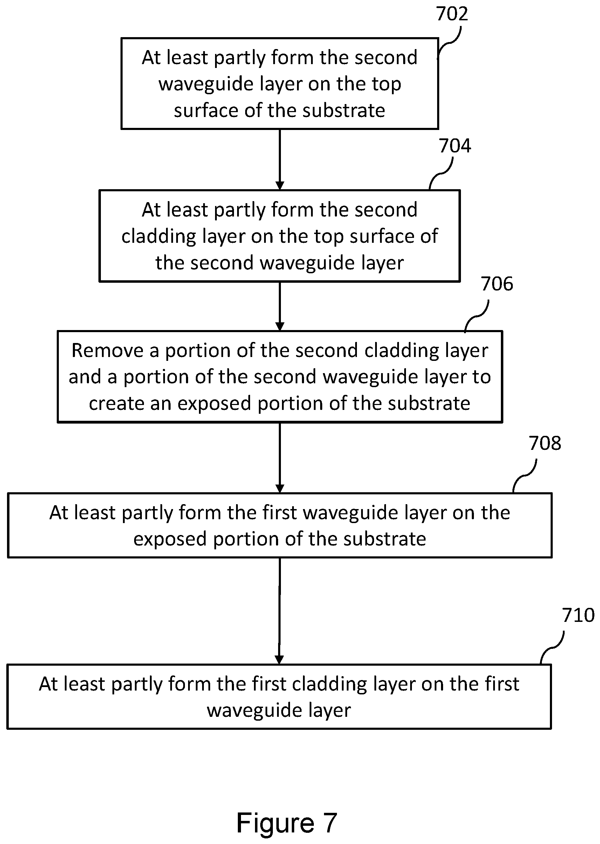

**In** some examples, the waveguide layers and the cladding layers are at least partly formed in a different manner. Figure 7 relates to method blocks that may be used to manufacture the examples shown in Figure 2, for example. Figure 7 is a block diagram illustrating some specific examples relating to at least partly forming the waveguide 104a, at least partly forming the first cladding layer 108a and at least partly forming the second cladding layer 116a. At block 702, the second waveguide layer 204 is at least partly formed on the top surface of the substrate 102a (e.g. to substantially cover all of the top surface). For example, one or more materials for the second waveguide layer 204 are deposited on the top surface of the substrate 102a as described above. At block 704, the second cladding layer 116a is at least partly formed on the top surface of the second waveguide layer 204 (e.g. to cover substantially all of the top surface). For example, the second cladding layer 116a is deposited on the top surface of the second waveguide layer 204.

At block 706, a portion of the second cladding layer 116a and the second waveguide layer 204 is removed to create an exposed portion of the substrate 102a. For example, a portion of the second cladding layer 116a is removed according to the desired location of the passive region 106a, and a respective portion of the second waveguide layer 204 underneath the removed portion of the second cladding layer 116a is also removed to create the exposed portion of the substrate 102. In some examples, two or more portions of the second cladding layer 116a and the second waveguide layer 204 are removed to provide two or more respective exposed portions of the substrate 102a. The number, arrangement, size and the like of the portions that are removed depends upon where the passive and active regions are desired and fabrication capabilities.

At block 708, the first waveguide layer 202 is at least partly formed on the exposed portion of the substrate. For example, one or more materials for the first waveguide layer 202 are deposited onto the exposed portion of the substrate 102a in the appropriate order. At block 710, the first cladding layer 108a is at least partly formed on the first waveguide layer 202 (e.g. by depositing the first cladding layer 108a on the first waveguide layer 202).

In some examples, the converse of the blocks illustrated in Figure 7 are performed. For example, the first waveguide layer 202 is at least partly formed on the top surface of the substrate 102a (e.g. to substantially cover all of the top surface). Then, the first cladding layer 108a is at least partly formed on the top surface of the first waveguide layer 202 (e.g. to substantially cover all of the top surface). A portion of the first cladding layer 108a and the first waveguide layer 202 is removed to create an exposed portion of the substrate 102a. The second waveguide layer 204 is at least partly formed on the exposed portion of the substrate 102a. Then, the second cladding layer 118a is at least partly formed on the second waveguide layer 204. In some examples, two or more portions of the first cladding layer 108a and the first waveguide layer 202 are removed to provide two or more respective exposed portions of the substrate 102a. The number, arrangement, size and the like of the portions that are removed depends upon where the passive and active regions are desired and fabrication capabilities.

In the examples of Figure 7 and the converse examples, one of the waveguide layers and the corresponding cladding layer are first at least partly formed. Then, portions are removed to expose portions of the substrate before the other of the waveguide layers and the corresponding cladding layer is at least partly formed (e.g. by depositing the relevant materials in the desired order).

In some examples, the active region forms a smaller part of the semiconductor structure. In such examples, it may be desired to at least partly form layers corresponding to the active region first (e.g. as in the methods illustrated in Figures 6 and 7). This provides that larger exposed portions are created. It may be desired that layers are at least partly formed on larger exposed portions (e.g. larger exposed portions of the substrate, e.g. where epitaxy regrowth is used).

In described examples, the first and second waveguide layers 202, 204 are formed to have substantially (within acceptable tolerances) the same thickness. Also, in described examples, the first and second cladding layers 108a, 116a are formed to have substantially (within acceptable tolerances) the same thickness. Accordingly, a semiconductor structure with integrated passive and active regions in provided in a manner that means individual control of different regions of cladding.

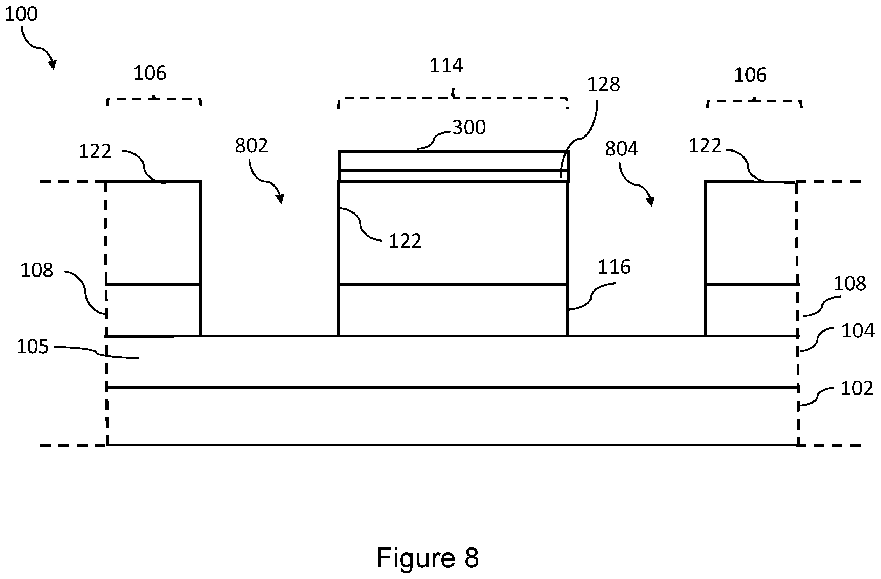

Referring again to Figure 3, a dashed line B-B is indicated. Figure 8 illustrates schematically a side cross section of a part of the semiconductor structure 100 along the dashed line B-B. There may be a similar side cross section for the semiconductor structure 100a of Figure 2, which is not shown. The dashed lines either side of the illustration indicate parts that are not shown. In these examples, the semiconductor structure 100 comprises a first etched portion 802 and a second etched portion 804. The first and second etched portions 802, 804 are defined according to the application of the semiconductor structure 100 to separate certain parts of the semiconductor structure 100. The etched portions 802, 804 may be filled with air or another material depending upon the application of the semiconductor structure in question.

For example, channel waveguides such as ridge waveguides or rib waveguides may be defined. In described methods, after the formation of the various described layers, material may be removed as desired to form different semiconductor structure according to the desired application.

A PIC comprising a semiconductor structure according to any of the described examples can be provided. In some examples, the active region 114, 114a corresponds to an optical amplifier of the PIC.

As the skilled person will appreciate, various techniques can be used to deposit the material in accordance with described examples. Such techniques include, for example, chemical vapour deposition techniques such as vapour phase epitaxy (VPE) metalorganic vapour-phase epitaxy (MOVPE) or molecular beam epitaxy (MBE). The skilled person will appreciate that etching techniques (for example, using patterned masks) are used to remove material in accordance with described examples.

The above examples are to be understood as illustrative examples. It is to be understood that any feature described in relation to any one example may be used alone, or in combination with other features described, and may also be used in combination with one or more features of any other of the examples, or any combination of any other of the examples. Furthermore, equivalents and modifications not described above may also be employed without departing from the scope of the accompanying claims.

Further examples in accordance with the present disclosure are given in the following clauses:
1. A semiconductor structure for a photonic integrated circuit, comprising:
   a substrate;
   a waveguide on the substrate;
   a passive region comprising a first cladding layer in contact with a first portion of the waveguide; and
   an active region comprising a second cladding layer different to the first cladding layer, the second cladding layer in contact with a second portion of the waveguide and the first cladding layer.
2. The semiconductor structure according to clause 1 comprising:
   a third cladding layer different to the first cladding layer and the second cladding layer, and in contact with the first cladding layer and the second cladding layer, the first cladding layer and the second cladding layer between the waveguide and the third cladding layer.
3. The semiconductor structure according to clause 2, wherein the third cladding layer comprises a dopant at a concentration of at least 5 × 10²³ *m*⁻³.
4. The semiconductor structure according to any one of the preceding clauses, wherein:
   the first cladding layer has substantially the same thickness as the second cladding layer.
5. The semiconductor structure according to any preceding clause, wherein:
   the thickness of each of the first cladding layer and the second cladding layer is greater than or equal to 4 × 10⁻⁷ *m* and/or less than or equal to 2 × 10⁻⁶ *m*.
6. The semiconductor structure according to any one of the preceding clauses, wherein:
   the waveguide comprises a single waveguide layer comprising the first portion of the waveguide and the second portion of the waveguide.
7. The semiconductor structure according to clause 6, wherein:
   the single waveguide layer comprises a plurality of sub-layers.
8. The semiconductor structure according to any one of clauses 1 to 7, wherein:
   the waveguide comprises a first waveguide layer in the passive region; and
   the waveguide comprises a second waveguide layer in the active region, the second waveguide layer different to the first waveguide layer, the first waveguide layer in contact with the second waveguide layer.
9. The semiconductor structure according to clause 8, wherein:
   a surface of the first cladding layer in contact with the second cladding layer is offset from a surface of the first waveguide layer in contact with the second waveguide layer.
10. The semiconductor structure according to any one of the preceding clauses, wherein:
   the active region comprises an electrical contact for injecting charge carriers into the active region.
11. The semiconductor structure according to clause 10, wherein:
   the active region comprises the first cladding layer and the second portion of the waveguide between the electrical contact and the substrate.
12. The semiconductor structure according to clause 10 or 11, wherein:
   the passive region comprises the second portion of the waveguide, the first portion of the waveguide not overlapped by the electrical contact.
13. The semiconductor structure according to any one of the preceding clauses, wherein:
   the first cladding layer is n-doped and the second cladding layer is p-doped.
14. The semiconductor structure according to any one of clauses 1 to 12, wherein:
   the first cladding layer is substantially dopant free; and
   the second cladding layer has a dopant concentration of at least 1 × 10¹⁴*cm*⁻³.
15. The semiconductor structure according to clause 14, wherein:
   the first cladding layer comprises Indium Phosphide; and
   the second cladding layer comprises Indium Phosphide doped with one of Zinc, Magnesium and Beryllium.
16. The semiconductor structure according to any one of the preceding clauses, wherein:
   the active region corresponds to an optical amplifier for the photonic integrated circuit.
17. The semiconductor structure according to any one of the preceding clauses, wherein:
   the first cladding layer is of a first material and the second cladding layer is of a second material different to the first material.
18. The semiconductor structure according to any one of the preceding clauses, wherein:
   the second cladding layer has a dopant concentration that changes with distance from the waveguide.
19. A photonic integrated circuit comprising a semiconductor structure according to any one of clauses 1 to 18.
20. A method of manufacturing a semiconductor structure for a photonic integrated circuit, the method comprising:
   at least partly forming a waveguide on a substrate;
   at least partly forming a first cladding layer for a passive region of the semiconductor structure, the first cladding layer in contact with a first portion of the waveguide; and
   at least partly forming a second cladding layer for an active region of the semiconductor structure, the second cladding layer in contact with a second portion of the waveguide and the first cladding layer.
21. The method according to clause 20 comprising:
   at least partly forming a third cladding layer on a top surface of the first cladding layer and a top surface of the second cladding layer, the third cladding layer in contact with the first cladding layer and the second cladding layer.
22. The method according to clause 20 or clause 21, wherein at least partly forming the first cladding layer comprises:
   at least partly forming the first cladding layer on a top surface of the waveguide; and
   removing a portion of the first cladding layer to provide an exposed portion of the waveguide, and
      at least partly forming the second cladding layer comprises:
   at least partly forming the second cladding layer onto the exposed portion.
23. The method according to clause 20 or 21, wherein at least partly forming the second cladding layer comprises:
   at least partly forming the second cladding layer on a top surface of the waveguide; and
   removing a portion of the second cladding layer to provide an exposed portion of the waveguide, and
      at least partly forming the first cladding layer comprises:
   at least partly forming the first cladding layer onto the exposed portion.
24. The method according to clause 20 or 21, wherein the waveguide of the semiconductor structure comprises:
   a first waveguide layer in the passive region; and
   a second waveguide layer in the active region, the first waveguide layer in contact with the second waveguide layer.
25. The method according to clause 24, wherein at least partly forming the waveguide comprises:
   at least partly forming the second waveguide layer on a top surface of the substrate;
   removing a portion of the second waveguide layer to provide an exposed portion of the substrate; and
   at least partly forming the first waveguide layer on the exposed portion of the substrate.
26. The method according to clause 24, wherein at least partly forming the waveguide comprises:
   at least partly forming the first waveguide layer on a top surface of the substrate;
   removing a portion of the first waveguide layer to provide an exposed portion of the substrate; and
   at least partly forming the second waveguide layer on the exposed portion of the substrate.
27. The method according to clause 24, comprising:
   at least partly forming the second waveguide layer on a top surface of the substrate;
   at least partly forming the second cladding layer on a top surface of the second waveguide layer;
   removing a portion of the second cladding layer and a portion of the second waveguide layer to provide an exposed portion of the substrate;
   at least partly forming the first waveguide layer on the exposed portion of the substrate; and
   at least partly forming the first cladding layer on the first waveguide layer.
28. The method according to clause 24, comprising:
   at least partly forming the first waveguide layer on a top surface of the substrate;
   at least partly forming the first cladding layer on a top surface of the first waveguide layer;
   removing a portion of the first cladding layer and a portion the first waveguide layer to provide an exposed portion of the substrate;
   at least partly forming the second waveguide layer on the exposed portion of the substrate; and
   at least partly forming the second cladding layer on the second waveguide layer.
29. The method according to any one of clauses 24 to 26, wherein:
   a surface of the first cladding layer in contact with the second cladding layer is offset from a surface of the first waveguide layer in contact with the second waveguide layer.

## Claims

1. A semiconductor structure for a photonic integrated circuit, comprising:
a substrate;
a waveguide on the substrate;
a passive region comprising a first cladding layer in contact with a first portion of the waveguide;
an active region comprising a second cladding layer different to the first cladding layer, the second cladding layer in contact with a second portion of the waveguide and the first cladding layer; and
a third cladding layer different to the first cladding layer and the second cladding layer, and in contact with the first cladding layer and the second cladding layer, the first cladding layer and the second cladding layer between the waveguide and the third cladding layer.

2. The semiconductor structure according to claim 1, wherein the third cladding layer comprises a dopant at a concentration of at least 5 × 10²³ *m*⁻³.

3. The semiconductor structure according to any one of the preceding claims, wherein:
the first cladding layer has substantially the same thickness as the second cladding layer.

4. The semiconductor structure according to any preceding claim, wherein:
the thickness of each of the first cladding layer and the second cladding layer is greater than or equal to 4 × 10⁻⁷ *m* and/or less than or equal to 2 × 10⁻⁶ *m*.

5. The semiconductor structure according to any one of the preceding claims, wherein:
the waveguide comprises a single waveguide layer comprising the first portion of the waveguide and the second portion of the waveguide.

6. The semiconductor structure according to claim 5, wherein:
the single waveguide layer comprises a plurality of sub-layers.

7. The semiconductor structure according to any one of claims 1 to 6, wherein:
the waveguide comprises a first waveguide layer in the passive region; and
the waveguide comprises a second waveguide layer in the active region, the second waveguide layer different to the first waveguide layer, the first waveguide layer in contact with the second waveguide layer.

8. The semiconductor structure according to any one of the preceding claims, wherein:
the active region comprises an electrical contact for injecting charge carriers into the active region; optionally wherein:
the active region comprises the first cladding layer and the second portion of the waveguide between the electrical contact and the substrate; and/or
the passive region comprises the second portion of the waveguide, the first portion of the waveguide not overlapped by the electrical contact.

9. The semiconductor structure according to any one of the preceding claims, wherein:
(i) the first cladding layer is n-doped and the second cladding layer is p-doped; or
(ii) the first cladding layer is substantially dopant free; and
the second cladding layer has a dopant concentration of at least 1 × 10¹⁴*cm*⁻³; optionally, wherein:
the first cladding layer comprises Indium Phosphide; and
the second cladding layer comprises Indium Phosphide doped with one of Zinc, Magnesium and Beryllium.

10. The semiconductor structure according to any one of the preceding claims, wherein:
(i) the active region corresponds to an optical amplifier for the photonic integrated circuit; and/or
(ii) the first cladding layer is of a first material and the second cladding layer is of a second material different to the first material; and/or
(iii) the second cladding layer has a dopant concentration that changes with distance from the waveguide.

11. A photonic integrated circuit comprising a semiconductor structure according to any one of claims 1 to 10.

12. A method of manufacturing a semiconductor structure for a photonic integrated circuit, the method comprising:
at least partly forming a waveguide on a substrate;
at least partly forming a first cladding layer for a passive region of the semiconductor structure, the first cladding layer in contact with a first portion of the waveguide;
at least partly forming a second cladding layer for an active region of the semiconductor structure, the second cladding layer in contact with a second portion of the waveguide and the first cladding layer; and
at least partly forming a third cladding layer on a top surface of the first cladding layer and a top surface of the second cladding layer, the third cladding layer in contact with the first cladding layer and the second cladding layer.

13. The method according to claim 12, wherein:
(i) at least partly forming the first cladding layer comprises:
at least partly forming the first cladding layer on a top surface of the waveguide; and
removing a portion of the first cladding layer to provide an exposed portion of the waveguide, and
at least partly forming the second cladding layer comprises:
at least partly forming the second cladding layer onto the exposed portion;
or
(ii) at least partly forming the second cladding layer comprises:
at least partly forming the second cladding layer on a top surface of the waveguide; and
removing a portion of the second cladding layer to provide an exposed portion of the waveguide, and
at least partly forming the first cladding layer comprises:
at least partly forming the first cladding layer onto the exposed portion.

14. The method according to claim 12, wherein the waveguide of the semiconductor structure comprises:
a first waveguide layer in the passive region; and
a second waveguide layer in the active region, the first waveguide layer in contact with the second waveguide layer.

15. The method according to claim 14, wherein:
(i) at least partly forming the waveguide comprises:
at least partly forming the second waveguide layer on a top surface of the substrate;
removing a portion of the second waveguide layer to provide an exposed portion of the substrate; and
at least partly forming the first waveguide layer on the exposed portion of the substrate; or
(ii) at least partly forming the waveguide comprises:
at least partly forming the first waveguide layer on a top surface of the substrate;
removing a portion of the first waveguide layer to provide an exposed portion of the substrate; and
at least partly forming the second waveguide layer on the exposed portion of the substrate; or
(iii) comprising: at least partly forming the second waveguide layer on a top surface of the substrate;
at least partly forming the second cladding layer on a top surface of the second waveguide layer;
removing a portion of the second cladding layer and a portion of the second waveguide layer to provide an exposed portion of the substrate;
at least partly forming the first waveguide layer on the exposed portion of the substrate; and
at least partly forming the first cladding layer on the first waveguide layer; or (iv) comprising: at least partly forming the first waveguide layer on a top surface of the substrate;
at least partly forming the first cladding layer on a top surface of the first waveguide layer;
removing a portion of the first cladding layer and a portion the first waveguide layer to provide an exposed portion of the substrate;
at least partly forming the second waveguide layer on the exposed portion of the substrate; and
at least partly forming the second cladding layer on the second waveguide layer.
